# EUROPÄISCHE PATENTSCHRIFT

(11) **EP 3 507 609 B1**
(45) Veröffentlichungstag und Bekanntmachung des Hinweises auf die Patenterteilung: **10.03.2021**
(21) Anmeldenummer: 17764513.2
(22) Anmeldetag: 17.08.2017
(51) Int. Cl.: G01R 31/08, G01R 31/52

(54) **VERFAHREN UND VORRICHTUNG ZUR LOKALISIERUNG EINES ISOLATIONSFEHLERS IN EINEM AN EIN STROMVERSORGUNGSSYSTEM ANGESCHLOSSENEN BETRIEBSMITTEL**
METHOD AND DEVICE FOR LOCATING AN INSULATION FAULT IN OPERATING MEANS CONNECTED TO A POWER SUPPLY SYSTEM
PROCÉDÉ ET DISPOSITIF POUR LOCALISER UN DÉFAUT D'ISOLATION DANS UN ÉQUIPEMENT RACCORDÉ À UN SYSTÈME D'ALIMENTATION ÉLECTRIQUE

(30) Priorität: 31.08.2016 DE 102016216450
(43) Veröffentlichungstag der Anmeldung: 10.07.2019
(73) Patentinhaber: Bender GmbH & Co. KG, 35305 Grünberg (DE)
(72) Erfinder: PIELER, Dirk, 35305 Grünberg (DE); WAGNER, Joachim, 35625 Hüttenberg (DE)
(74) Vertreter: advotec.
(86) Internationale Anmeldenummer: PCT/EP2017/070819
(87) Internationale Veröffentlichungsnummer: WO 2018/041638

(56) Entgegenhaltungen:
- EP-A1- 2 796 886
- DE-A1-102011 050 346

## Beschreibung

Die Erfindung betrifft ein Verfahren und eine Vorrichtung zur Lokalisierung eines Isolationsfehlers in einem an ein Stromversorgungssystem angeschlossenen Betriebsmittel.

Die Grundlage für eine gesicherte Versorgung mit elektrischer Energie bilden zuverlässige Stromversorgungssysteme. Die hohe Verfügbarkeit der Stromversorgung verlangt elektrische Anlagen hoher Komplexität, die mit Schutz- und Überwachungseinrichtungen versehen sind, um Fehler rechtzeitig zu erkennen und eine zeit- und kostensparende Fehlersuche durchführen zu können.

In einem geerdeten Stromversorgungssystem kann sich ein Isolationsfehler beispielsweise als Differenzstrom äußern, der zwar nicht zur Auslösung einer Fehlerstrom-Schutzeinrichtung führt, aber langfristig eine schleichende Gefahr insbesondere für Personen darstellt, die mit elektrisch leitfähigen Anlagenteilen in Berührung kommen. In ungeerdeten Stromversorgungssystemen kann ein sinkender Isolationswiderstandswert die Betriebssicherheit gefährden. Es gilt also, derartige Isolationsfehler frühzeitig zu erkennen, zu lokalisieren und so schnell wie möglich zu beseitigen.

Als elektrische Überwachungseinrichtung werden in geerdeten Netzen in bekannter Weise Differenzstrom-Überwachungsgeräte (RCM) eingesetzt, die einen (erhöhten) Differenzstrom in dem Stromversorgungssystem erkennen. In ungeerdeten Stromversorgungssystemen kommen als elektrische Überwachungseinrichtungen Isolationsüberwachungsgeräte zum Einsatz, die kontinuierlich prüfen, ob der Isolationswiderstand der gesamten elektrischen Anlage - des Stromversorgungssystems einschließlich der daran angeschlossenen elektrischen Betriebsmittel wie Verbraucher oder Generatoren- einen vorgeschriebenen Mindestwert nicht unterschreitet.

Wird von dem Überwachungsgerät ein Isolationsfehler gemeldet, so ist damit der Fehler zwar grundsätzlich erkannt, aber in den meisten Fällen noch nicht lokalisiert. Die Fehlerlokalisierung ist in der Regel eine zeit- und kostenintensive Aufgabe, da der Fehler möglichst schnell zu beseitigen ist, der Fehlerort jedoch noch unbekannt ist.

Nach heutigem Stand der Technik findet entweder eine manuelle Fehlersuche mittels portablen Suchgeräten oder eine automatisierte Suche mit fest installierten Fehlersucheinrichtungen statt, zumeist unter Zuhilfenahme von Messstromwandlern.

Je nach angestrebter örtlicher Auflösung ist dazu eine Vielzahl von Messstromwandlern erforderlich. Je mehr Selektivität gewünscht wird, desto mehr Messstromwandler müssen installiert werden. Mit genügend vielen Messstromwandlern kann eine Selektivität bis zur einzelnen Steckdose erreicht werden, was aber in nachteiliger Weise mit entsprechendem Material- und Installationsaufwand verbunden ist.

So zeigt die Offenlegungsschrift EP 2 796 886 A1 eine Schaltungsanordnung zum Lokalisieren von Isolationsfehlern in verzweigten Gleichspannungsnetzen. Die Schaltungsanordnung weist eine Fehlererkennungseinrichtung auf, welche die erste oder zweite Phase mit Erdpotenzial verbindet, was zu einer messbaren Änderung des Fehlerstroms in dem fehlerbehafteten Abzweig führt. Die Stromänderung wird dabei mit einer Erfassungseinrichtung in Form einer Summenstrommessung erfasst.

Die Fehlersuche ist daher insbesondere bei Fehlern, die in angeschlossenen Betriebsmitteln, beispielsweise in Verbrauchern oder Generatoren, auftreten, oftmals sehr aufwändig.

Der vorliegenden Erfindung liegt somit die Aufgabe zu Grunde, ein Verfahren und eine Vorrichtung vorzuschlagen, die die Isolationsfehlerlokalisierung für an ein Stromversorgungssystem angeschlossene Betriebsmittel gegenüber dem Stand der Technik weniger zeit- und kostenaufwändig gestalten. Dabei ist die Erfindung durch das Verfahren gemäß Anspruch 1 und die Vorrichtung gemäß Anspruch 5 definiert.

Diese Aufgabe wird durch ein Verfahren gelöst, welches die folgenden Verfahrensschritte umfasst:
kontinuierliches Erfassen mindestens einer elektrischen Messgröße in dem Stromversorgungssystem,
Erkennen eines Einschalt- oder Ausschaltereignisses in einem zeitlichen Verlauf der erfassten elektrischen Messgröße und Zuordnen des Einschalt- bzw. Ausschaltereignisses zu einem das Einschalt- bzw. Ausschaltereignis verursachenden Betriebsmittel durch Korrelationsberechnungen auf Basis der erfassten elektrischen Messgröße und einem gespeicherten, für das Betriebsmittel charakteristischen Signalverlauf,
Aufzeichnen aller Einschalt- und Ausschaltereignisse mit Einschalt- bzw. Aus-schaltzeitpunkt und zugeordnetem Betriebsmittel,

Erkennen des Isolationsfehlers mit zugehörigem Fehlerzeitpunkt, Prüfen, ob der Fehlerzeitpunkt mit einem aufgezeichneten Einschaltzeitpunkt übereinstimmt,
falls der Fehlerzeitpunkt mit einem aufgezeichneten Einschaltzeitpunkt übereinstimmt, Signalisieren, dass der Fehler in dem zu diesem Einschaltzeitpunkt eingeschalteten Betriebsmittel aufgetreten ist.

Im Regelbetrieb des Stromversorgungssystems und der angeschlossenen Betriebsmittel wird eine elektrische Messgröße, wie ein Strom- oder Spannungsverlauf (Betriebsstrom oder Betriebsspannung), in dem Stromversorgungssystem kontinuierlich erfasst. Die Erfassung kann an zentraler Stelle geschehen, so dass sämtliche in dem Stromversorgungssystem betriebsmäßig auftretenden Strom- und Spannungsänderungen in eine Messung des Gesamtstroms oder der Gesamtspannung mit einbezogen werden. Das Ein- und Ausschalten eines bestimmten Betriebsmittels (Einschalt-/Ausschaltereignis), beispielsweise eines Antriebsmotors, kann anhand des gemessenen zeitlichen Verlaufs der elektrischen Messgröße erkannt werden, da jedes Betriebsmittel ein individuelles Ein- und Ausschaltverhalten aufweist, das mit einem für dieses Betriebsmittel charakteristischen Signalverlauf verbunden ist. Dieser charakteristische Signalverlauf kann ein zeitlicher Verlauf der elektrischen Messgröße selbst (Strom-/Spannungsverlauf mit Strom-/Spannungsspitzen) oder ein daraus abgeleitetes Signal wie beispielsweise ein durch FourierTransformation gewonnenes Frequenzspektrum sein.

Derartige für das Betriebsmittel charakteristische Signalverläufe sind jeweils für alle zu überwachenden Betriebsmittel gespeichert und werden zur Erkennung eines Einschaltereignisses bzw. eines Ausschaltereignisses in Korrelationsberechnungen mit der erfassten elektrischen Messgröße oder mit einem analog zu dem gespeicherten charakteristischen Signalverlauf aus der elektrischen Messgröße abgeleiteten Signal herangezogen, um das Einschalt-/Ausschaltereignis dem dieses Ereignis verursachenden Betriebsmittel zuzuordnen.

Alle Einschaltereignisse und alle Ausschaltereignisse mit zugehörigem Einschalt- bzw. Ausschaltzeitpunkt und zugeordnetem Betriebsmittel werden erfasst und in einer Protokolldatei aufgezeichnet.

Wird nun von einer elektrischen Überwachungseinrichtung, beispielsweise von einem Isolationsüberwachungsgerät oder einem Differenzstrom-Überwachungsgerät, ein Isolationsfehler mit zugehörigem Fehlerzeitpunkt gemeldet, so liefert diese Meldung zunächst nur die Erkenntnis, dass in dem von der Überwachungseinrichtung kontrollierten Netzabschnitt ein Isolationsfehler aufgetreten ist. Ob ein Betriebsmittel und welches Betriebsmittel als Fehlerverursacher gilt, ist unbekannt.

Um ein fehlerhaftes Betriebsmittel zu identifizieren, wird daher geprüft, ob der Fehlerzeitpunkt mit einem aufgezeichneten Einschaltzeitpunkt eines Betriebsmittels übereinstimmt. Es wird also festgestellt, ob zu dem Fehlerzeitpunkt ein Betriebsmittel eingeschaltet wurde. Dazu werden die in der Protokolldatei aufgezeichneten Einträge der Einschalt- und Ausschaltereignisse mit den zugehörigen Einschalt- bzw. Ausschaltzeitpunkten und den zugeordneten Betriebsmitteln durchsucht. Falls der Fehlerzeitpunkt mit einem aufgezeichneten Einschaltzeitpunkt übereinstimmt, ist das diesem Einschaltzeitpunkt zugeordnete Betriebsmittel als Fehlerursache identifiziert.

In kostengünstiger Weise kann somit auf eine fest installierte Fehlersucheinrichtung verzichtet werden. Insbesondere ist bei einer Erweiterung der elektrischen Anlage mit zusätzlichen Betriebsmitteln keine Nachinstallation weiterer Fehlersucheinrichtungen erforderlich.

Gegenüber einer manuellen Fehlersuche gestaltet sich die erfindungsgemäße Fehlerlokalisierung wenig zeitaufwändig. Zudem ist keine Abschaltung der elektrischen Anlage während der Lokalisierung erforderlich.

Grundsätzlich wird bei diesen Betrachtungen davon ausgegangen, dass der Isolationsfehler in dem betroffenen Betriebsmittel dessen Ein-/Ausschaltverhalten nur minimal beeinflusst, sodass der charakteristische Signalverlauf im fehlerfreien wie im fehlerhaften Fall identisch ist. Mit dem erfindungsgemäßen Verfahren wird im Vorfeld bei erstem Auftreten geringfügiger Änderungen des Isolationszustandes der elektrischen Anlage dieser Informationsvorsprung im Hinblick auf eine Beseitigung der Fehlerursache genutzt.

Mit Vorteil ergibt sich der charakteristische Signalverlauf in einem Lernmodus aus einem einmaligen Erfassen eines zeitlichen Verlaufs der elektrischen Messgröße beim Einschalten und beim Ausschalten des Betriebsmittels.

Wird ein Betriebsmittel erstmals an das Stromversorgungssystem angeschlossen und soll dieses Betriebsmittel in die Fehlerlokalisierung mit einbezogen werden, so muss für dieses Betriebsmittel ein charakteristischer Signalverlauf hinterlegt werden. Dies geschieht in einem Lernmodus durch einmaliges Erfassen eines zeitlichen Verlaufs der elektrischen Messgröße wie dem Strom oder der Spannung beim Einschalten und beim Ausschalten des Betriebsmittels. Dabei kann der erfasste zeitliche Verlauf selbst oder ein davon abgeleitetes Signal, wie beispielsweise die Fourier-Transformierte der elektrischen Messgröße oder eine mit Mitteln der digitalen Signalverarbeitung (Filterung) weiterverarbeitete Messgröße, als charakteristischer Signalverlauf gespeichert und zur Korrelation mit der aktuell erfassten elektrischen Messgröße oder eines davon abgeleiteten Signals herangezogen werden.

Weiterhin wird, falls der Fehlerzeitpunkt mit einem aufgezeichneten Einschaltzeitpunkt nicht übereinstimmt, geprüft, ob der Fehlerzeitpunkt innerhalb eines von einem der Einschaltzeitpunkte und einem der Ausschaltzeitpunkte gebildeten Zeitintervalls eines der Betriebsmittel liegt.

Das erfindungsgemäße Verfahren eignet sich nur, um fehlerhafte Betriebsmittel zu lokalisieren, die in Betrieb genommen werden. Der Isolationsfehler muss also vor Einschalten des Betriebsmittels aufgetreten sein und sich zum Einschaltzeitpunkt in einer Überwachungseinrichtung als solcher bemerkbar machen. Der Fehlerzeitpunkt und ein Einschaltzeitpunkt müssen übereinstimmen, um dem Fehler ein Betriebsmittel zuordnen zu können. Wird keine Übereinstimmung festgestellt, so kann durch die Prüfung, ob der Fehlerzeitpunkt innerhalb eines von einem der Einschaltzeitpunkte und einem der Ausschaltzeitpunkte gebildeten Zeitintervalls eines der Betriebsmittel liegt, zumindest ermittelt werden, welche Betriebsmittel zum Fehlerzeitpunkt eingeschaltet waren. Hierdurch kann die Fehlersuche eingegrenzt und damit schneller zum Erfolg geführt werden.

Mit Vorteil wird für einen erkannten und nicht mehr andauernden Isolationsfehler neben dem Fehlerzeitpunkt ein Fehlerendzeitpunkt erfasst, gespeichert und mit den gespeicherten Ausschaltzeitpunkten der Betriebsmittel verglichen.

Als ergänzende Maßnahme kann in dem Fall, dass zum Einschaltzeitpunkt ein Isolationsfehler vorliegt, der aber zu einem Fehlerendzeitpunkt wieder verschwindet, dieser Fehlerendzeitpunkt mit den gespeicherten Ausschaltzeitpunkten verglichen werden, um ein fehlerhaftes Betriebsmittel zusätzlich durch sein Ausschaltverhalten zu identifizieren.

Der Vergleich des Fehlerendzeitpunktes mit den gespeicherten Ausschaltzeitpunkten kann auch dann zur Identifizierung eines fehlerhaften Betriebsmittels herangezogen werden, falls der Isolationsfehler erst bei eingeschaltetem Betriebsmittel auftritt, also keine Übereinstimmung des Fehlerzeitpunktes mit einem aufgezeichneten Einschaltzeitpunkt feststellbar ist, das Betriebsmittel aber zwischenzeitlich ausgeschaltet wurde.

In Umsetzung des erfindungsgemäßen Verfahrens wird die der Erfindung zugrunde liegende Aufgabe durch eine Vorrichtung gelöst, die eine elektrische Überwachungseinrichtung zur Erkennung eines Isolationsfehlers mit zugehörigem Fehlerzeitpunkt und eine mit der Überwachungseinrichtung über einen Kommunikationskanal verbundene Erkennungseinrichtung zur Erkennung des fehlerhaften Betriebsmittels anhand eines für das jeweilige Betriebsmittel charakteristischen Signalverlaufs beim Einschalten und beim Ausschalten des Betriebsmittels zu einem Fehlerzeitpunkt umfasst.

Grundlegende Funktionsblöcke der erfindungsgemäßen Vorrichtung sind eine elektrische Überwachungseinrichtung, die einen Isolationsfehler erkennt und mit zugehörigem Fehlerzeitpunkt über einen Kommunikationskanal kommuniziert, und eine Erkennungseinrichtung, die ein fehlerhaftes Betriebsmittel anhand eines für das jeweilige Betriebsmittel charakteristischen Einschalt-/Ausschalt-Signalverlaufs erkennt.

Bevorzugt ist die elektrische Überwachungseinrichtung als Isolationsüberwachungsgerät im ungeerdeten Stromversorgungssystem oder als Differenzstrom-Überwachungsgerät im geerdeten Stromversorgungssystem ausgeführt.

Als Isolationsüberwachungsgerät ist die elektrische Überwachungseinrichtung an zentraler Stelle in dem Stromversorgungssystem installiert und überwacht den Isolationswiderstand des gesamten Stromversorgungssystems. Falls der Isolationswiderstand infolge eines Isolationsfehlers einen Mindestwert unterschreitet, wird eine Fehlermeldung erzeugt und mit Fehlerzeitpunkt kommuniziert.

Die elektrische Überwachungseinrichtung kann im geerdeten Stromversorgungssystem als Differenzstrom-Überwachungsgerät ausgeführt sein. In diesem Fall umfasst die elektrische Überwachungseinrichtung einen oder mehrere Messstromwandler, der/die in dem Stromversorgungsnetz installiert ist/sind, um Differenzströme, die aufgrund eines Isolationsfehlers entstehen, zu erkennen. Übersteigt der Differenzstrom einen bestimmten Wert, wird eine Fehlermeldung erzeugt und mit Fehlerzeitpunkt kommuniziert.

In vorteilhafter Ausgestaltung umfasst die Erkennungseinrichtung folgende Einrichtungen:
eine Erfassungseinrichtung zum kontinuierlichen Erfassen mindestens einer elektrischen Messgröße in dem Stromversorgungssystem,
eine Auswerteeinrichtung zum Erkennen eines Einschalt-/Ausschaltereignisses in einem zeitlichen Verlauf der erfassten elektrischen Messgröße und zum Zuordnen des Einschalt-/Ausschaltereignisses zu einem das Einschalt-/Ausschaltereignis verursachenden Betriebsmittel,
eine Speichereinrichtung zum Aufzeichnen aller Einschalt-/Ausschaltereignisse mit Einschalt-/Ausschaltzeitpunkt und zugeordnetem Betriebsmittel,
eine Signalisierungseinrichtung zum Prüfen, ob der Fehlerzeitpunkt/ein Fehlerendzeitpunkt mit einem aufgezeichneten Einschaltzeitpunkt/Ausschaltzeitpunkt übereinstimmt, und zum Signalisieren des fehlerhaften Betriebsmittels.

Die Erfassungseinrichtung dient dem kontinuierlichen Erfassen einer elektrischen Messgröße an einer zentralen Stelle in dem Stromversorgungssystem. Die elektrische Messgröße kann ein Strom- oder ein Spannungsverlauf sein, der zu einem Einschalt- bzw. Ausschaltzeitpunkt eines Betriebsmittels (Einschalt-/Ausschaltereignis) für dieses Betriebsmittel charakteristische Merkmale wie Strom- oder Spannungsspitzen oder Frequenzanteile aufweist.

Die Auswerteeinrichtung erkennt das Einschalt-/Ausschaltereignis in dem zeitlichen Verlauf der erfassten elektrischen Messgröße und kann diesem Ereignis - im Rahmen der zu überwachenden Betriebsmittel - das verursachende Betriebsmittel zuordnen, da für jedes zu überwachende Betriebsmittel ein charakteristischer Signalverlauf hinterlegt ist, der mit der erfassten elektrischen Messgröße oder mit einem daraus abgeleiteten Signal korreliert werden kann.

Die Speichereinrichtung beinhaltet eine Protokolldatei, in der sämtliche Einschalt-/Ausschaltereignisse mit Einschalt-/Ausschaltzeitpunkt und zugeordnetem Betriebsmittel verzeichnet sind.

Sobald eine Fehlermeldung mit Fehlerzeitpunkt an die Erkennungseinrichtung übertragen wird, prüft die Signalisierungseinrichtung, ob der Fehlerzeitpunkt/ein Fehlerendzeitpunkt mit einem aufgezeichneten Einschaltzeitpunkt/Ausschaltzeitpunkt übereinstimmt. Werden Übereinstimmungen festgestellt, kann das fehlerhafte Betriebsmittel signalisiert werden.

Der Vergleich eines Fehlerendzeitpunktes mit einem Ausschaltzeitpunkt des Betriebsmittels ist dann sinnvoll, wenn der Isolationsfehler erst auftritt, nachdem das Betriebsmittel eingeschaltet wurde und zwischenzeitlich mit Abschaltung des Betriebsmittels wieder verschwindet. In diesem Fall kann das fehlerhafte Betriebsmittel anhand des charakteristischen Signalverlaufs zum Ausschaltzeitpunkt identifiziert werden.

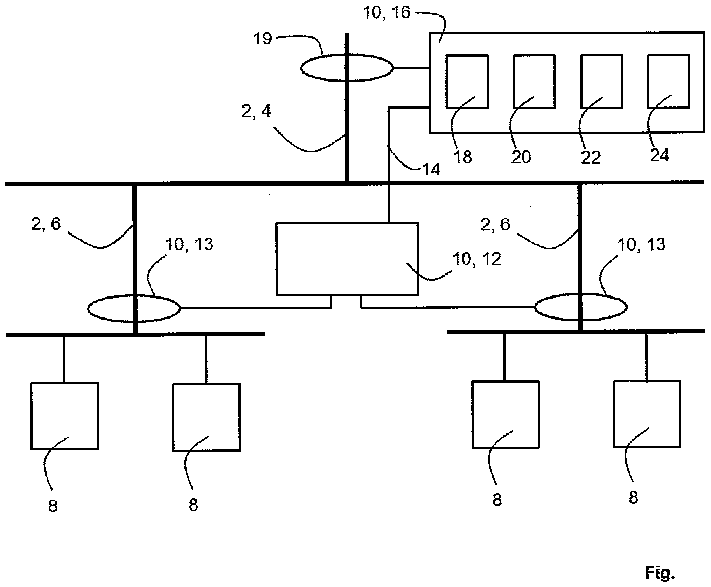

Die vorteilhaften Ausgestaltungsmerkmale sind in der nachfolgenden Beschreibung und in der Zeichnung dargelegt, die beispielhaft eine bevorzugte Ausführungsform der Vorrichtung in Umsetzung des erfindungsgemäßen Verfahrens erläutern.

Die **Figur** zeigt in schematischer Darstellung eine erfindungsgemäße Vorrichtung zur Lokalisierung eines Isolationsfehlers in einem an ein Stromversorgungssystem angeschlossen Betriebsmittel.

Dargestellt ist ein verzweigtes Stromversorgungssystem 2, welches aus einem Hauptsystem 4 und zwei Subsystemen 6 besteht. An die Subsysteme 6 sind Verbraucher oder Generatoren als elektrische Betriebsmittel 8 angeschlossen.

Die erfindungsgemäße Vorrichtung 10 zur Lokalisierung des Isolationsfehlers ist in einem funktionalen Blockdiagramm dargestellt und umfasst als grundlegende Funktionsblöcke eine elektrische Überwachungseinrichtung 12, die über einen Kommunikationskanal 14 mit einer Erkennungseinrichtung 16 verbunden ist.

Die elektrische Überwachungseinrichtung 12 ist vorliegend als Differenzstrom-Überwachungsgerät mit zwei Messstromwandlern 13 ausgeführt. Die Messstromwandler 13 erfassen in den Subsystemen 6 fließende Differenzströme, die dann auftreten, falls eines der Betriebsmittel 8 einen Isolationsfehler aufweist. Übersteigt ein gemessener Differenzstrom einen voreinstellbaren Wert, erzeugt das Differenzstrom-Überwachungsgerät 12 eine Fehlermeldung und übermittelt diese mit zugehörigem Fehlerzeitpunkt über den Kommunikationskanal 14 an die Erkennungseinrichtung 16.

Die Erkennungseinrichtung 16 umfasst eine Erfassungseinrichtung 18, eine Auswerteeinrichtung 20, eine Speichereinrichtung 22 und eine Signalisierungseinrichtung 24.

Zu der Erfassungseinrichtung 18 gehört in der dargestellten Ausführung ein weiterer Messstromwandler 19, der einen Betriebsstrom als elektrische Messgröße zentral in dem Hauptsystem 4 des Stromversorgungssystems 2 kontinuierlich erfasst. In vorteilhafter Weise genügt im Allgemeinen die Installation nur eines Messstromwandlers 19.

Auf der Basis des erfassten zeitlichen Verlaufs des Betriebsstroms und von zuvor für die Betriebsmittel 8 hinterlegten charakteristischen Signalverläufen erkennt die Auswerteeinrichtung 20 mittels Korrelationsberechnungen, wann ein Einschalt-/Ausschaltereignis eingetreten ist, und ordnet dieses Ereignis mit zugehörigem Einschalt-/Ausschaltzeitpunkt dem verursachenden Betriebsmittel 8 zu.

Als Ergebnis dieser Auswertungen entsteht in der Speichereinrichtung 22 eine Protokolldatei, in der sämtliche Einschalt-/Ausschaltereignisse mit Einschalt-/Ausschaltzeitpunkt und zugeordnetem Betriebsmittel 8 verzeichnet sind.

Erkennt die elektrische Überwachungseinrichtung 12 nun einen Fehler und übermittelt den zugehörigen Fehlerzeitpunkt an die Erkennungseinrichtung 16, so greift die Signalisierungseinrichtung 24 auf die Protokolldatei zu und durchsucht diese daraufhin, ob der übermittelte Fehlerzeitpunkt mit einem aufgezeichneten Einschaltzeitpunkt übereinstimmt. Da entsprechend der Protokolldatei dem Einschaltzeitpunkt ein Betriebsmittel 8 zugeordnet ist, kann die Signalisierungseinrichtung 24 im Fall einer Übereinstimmung zwischen Fehlerzeitpunkt und Einschaltzeitpunkt das Fehler verursachende Betriebsmittel 8 identifizieren und anzeigen.

Die in der Figur dargestellte schematische Darstellung bezieht sich auf ein geerdetes Stromversorgungssystem 2. Im Fall eines ungeerdeten Stromversorgungssystems (2) ist die elektrische Überwachungseinrichtung (12) als ein der Norm IEC 61557-8 entsprechendes Isolationsüberwachungsgerät ausgeführt, welches - wie im dargestellten Fall des geerdeten Stromversorgungssystems 2 - über den Kommunikationskanal 14 mit der Erkennungseinrichtung 16 verbunden ist.

## Patentansprüche

1. Verfahren zur Lokalisierung eines Isolationsfehlers in einem an ein Stromversorgungssystem (2) angeschlossenen Betriebsmittel (8), umfassend die Verfahrensschritte:
kontinuierliches Erfassen mindestens einer elektrischen Messgröße in dem Stromversorgungssystem (2),
Erkennen eines Einschalt- oder Ausschaltereignisses in einem zeitlichen Verlauf der erfassten elektrischen Messgröße und
Zuordnen des Einschalt- bzw. Ausschaltereignisses zu einem das Einschalt- bzw. Ausschaltereignis verursachenden Betriebsmittel (8) durch Korrelationsberechnungen auf Basis der erfassten elektrischen Messgröße und einem gespeicherten, für das Betriebsmittel (8) charakteristischen Signalverlauf,
Aufzeichnen aller Einschalt- und Ausschaltereignisse mit Einschalt- bzw. Ausschaltzeitpunkt und zugeordnetem Betriebsmittel (8),
Erkennen des Isolationsfehlers mit zugehörigem Fehlerzeitpunkt, Prüfen, ob der Fehlerzeitpunkt mit einem aufgezeichneten Einschaltzeitpunkt übereinstimmt,
falls der Fehlerzeitpunkt mit einem aufgezeichneten Einschaltzeitpunkt übereinstimmt, Signalisieren, dass der Fehler in dem zu diesem Einschaltzeitpunkt eingeschalteten Betriebsmittel (8) aufgetreten ist.

2. Verfahren nach Anspruch 1,
**dadurch gekennzeichnet,**
**dass** sich der charakteristische Signalverlauf in einem Lernmodus aus einem einmaligen Erfassen eines zeitlichen Verlaufs der elektrischen Messgröße beim Einschalten und beim Ausschalten des Betriebsmittels (8) ergibt.

3. Verfahren nach Anspruch 1 oder 2,
**dadurch gekennzeichnet,**
**dass**, falls der Fehlerzeitpunkt mit einem aufgezeichneten Einschaltzeitpunkt nicht übereinstimmt, geprüft wird, ob der Fehlerzeitpunkt innerhalb eines von einem der Einschaltzeitpunkte und einem der Ausschaltzeitpunkte gebildeten Zeitintervalls eines der Betriebsmittel (8) liegt.

4. Verfahren nach einem der Ansprüche 1 bis 3,
**dadurch gekennzeichnet,**
**dass** für einen erkannten und nicht mehr andauernden Isolationsfehler neben dem Fehlerzeitpunkt ein Fehlerendzeitpunkt erfasst, gespeichert und mit den gespeicherten Ausschaltzeitpunkten der Betriebsmittel (8) verglichen wird.

5. Vorrichtung (10) zur Lokalisierung eines Isolationsfehlers in einem an ein Stromversorgungssystem (2) angeschlossenen Betriebsmittel (8), umfassend
eine elektrische Überwachungseinrichtung (12) zur Erkennung eines Isolationsfehlers mit zugehörigem Fehlerzeitpunkt und eine mit der Überwachungseinrichtung (12) über einen Kommunikationskanal (14) verbundene Erkennungseinrichtung (16) zur Erkennung des fehlerhaften Betriebsmittels (8) anhand eines für das jeweilige Betriebsmittel (8) charakteristischen Signalverlaufs beim Einschalten und beim Ausschalten des Betriebsmittels (8) zu einem Fehlerzeitpunkt, wobei
die Erkennungseinrichtung (16) weiter umfasst
eine Erfassungseinrichtung (18) zum kontinuierlichen Erfassen mindestens einer elektrischen Messgröße in dem Stromversorgungssystem,
eine Auswerteeinrichtung (20) zum Erkennen eines Einschalt- oder Ausschaltereignisses in einem zeitlichen Verlauf der erfassten elektrischen Messgröße und zum Zuordnen des Einschalt- bzw. Ausschaltereignisses zu einem das Einschalt- bzw. Ausschaltereignis verursachenden Betriebsmittel,
eine Speichereinrichtung (22) zum Aufzeichnen aller Einschalt- und Ausschaltereignisse mit Einschalt- bzw. Ausschaltzeitpunkt und zugeordnetem Betriebsmittel,
eine Signalisierungseinrichtung (24) zum Prüfen, ob der Fehlerzeitpunkt und ein Fehlerendzeitpunkt mit einem aufgezeichneten Einschaltzeitpunkt bzw. Ausschaltzeitpunkt übereinstimmt, und zum Signalisieren des fehlerhaften Betriebsmittels (8).

6. Vorrichtung (10) nach Anspruch 5,
**dadurch gekennzeichnet,**
**dass** die elektrische Überwachungseinrichtung (12) als Isolationsüberwachungsgerät oder als Differenzstrom-Überwachungsgerät ausgeführt ist.

## Claims

1. A method for localizing an insulation fault in an operating means (8) connected to a power supply system (2), comprising the method steps:
continually capturing at least one electric measure in the power supply system (2),
identifying an instance of turning on/off in a temporal progress of the captured electric measure, and
assigning the instance of turning on/off to an operating means (8) effecting the instance of turning on/off via correlation calculations based on the captured electric measure and a stored signal progress characteristic to the operating means (8),
recording all instances of turning on/off with turning-on/-off times and respective operating means (8),
identifying the insulation fault with a respective fault time,
examining whether the fault time coincides with a recorded turning-on time,
should the fault time coincide with a recorded turning-on time, signaling that the fault occurred in the operating means (8) turned on at this turning-on time.

2. The method according to claim 1,
**characterized in that**
the characteristic signal progress is yielded in a learning mode by capturing once a temporal progress of the electric measure when turning the operating means (8) on and off.

3. The method according to claim 1 or 2,
**characterized in that**
should the fault time not coincide with a recorded turning-on time, it is examined whether the fault time lies within a temporal interval of one of the operating means (8) which is formed by one of the turning-on times and one of the turning-off times.

4. The method according to one of the claims 1 to 3,
**characterized in that**
for an identified and no longer persisting insulation fault, a fault end time is captured, stored and compared to the stored turning-off times of the operating means (8) in addition to the fault time.

5. A device (10) for localizing an insulation fault in an operating means (8) connected to a power supply system (2), comprising an electric monitoring device (12) for identifying an insulation fault with a respective fault time, and an identifying device (16) connected to the monitoring device (12) via a communication channel (14) and serving to identify the faulty operating means (8) by means of a signal progress characteristic to the particular operating means (8) when turning the operating means (8) on and off at a fault time, the identifying device (16) further comprising a capturing device (18) for continually capturing at least one electric measure in the power supply system,
an evaluation device (20) for identifying an instance of turning on/off in a temporal progress of the captured electric measure and for assigning the instance of turning on/off to an operating means effecting the turning on/off,
a storage device (22) for recording all instances of turning on/off with a turning-on/-off time and assigned operating means,
a signaling device (24) for examining whether the fault time and a fault end time coincide with a recorded turning-on/-off time and for signaling the faulty operating means (8).

6. The device (10) according to claim 5,
**characterized in that**
the electric monitoring device (12) is configured as an insulation monitoring device or a residual-current monitoring device.

## Revendications

1. Procédé pour localiser un défaut d'isolement dans un moyen d'opération (8) relié à un système d'alimentation en courant (2), le procédé comprenant les étapes suivantes :
capter continument au moins un mesurande électrique dans le système d'alimentation en courant (2),
identifier un événement de mise en marche/à l'arrêt dans une propagation en espace temporel du mesurande électrique capté, et
associer l'événement de mise en marche/à l'arrêt à un moyen d'opération (8) causant l'événement de mise en marche/à l'arrêt par des calculs d'une corrélation sur la base du mesurande électrique capté et d'une propagation de signal stockée et caractéristique pour le moyen d'opération (8),
enregistrer tous les événements de mise en marche/à l'arrêt avec les temps de mise en marche/à l'arrêt et le moyen d'opération (8) associé,
identifier le défaut d'isolement avec un temps d'erreur respectif,
examiner si le temps d'erreur coïncide avec un temps de mise en marche enregistré,
si le temps d'erreur coïncide avec un temps de mise en marche enregistré, signaler que le défaut s'est passé dans le moyen d'opération (8) mis en marche à ce temps de mise en marche.

2. Procédé selon la revendication 1,
**caractérisé en ce que**
la propagation de signal caractéristique est obtenue dans un mode d'apprentissage en captant uniquement une propagation en espace temporel du mesurande électrique quand le moyen d'opération (8) est mis en marche/à l'arrêt.

3. Procédé selon la revendication 1 ou 2,
**caractérisé en ce que**,
si le temps d'erreur ne coïncide pas avec un temps de mise en marche enregistré, on examine si le temps d'erreur est dans un intervalle temporel d'un des moyens d'opération (8) qui est formé par un des temps de mise en marche et un des temps de mise à l'arrêt.

4. Procédé selon l'une quelconque des revendications 1 à 3,
**caractérisé en ce que**,
pour un défaut d'isolement identifié et ne plus persistant, un temps de fin d'erreur est capté, stocké et comparé au temps de mise à l'arrêt stocké du moyen d'opération (8) en plus du temps d'erreur.

5. Dispositif (10) pour localiser un défaut d'isolement dans un moyen d'opération (8) relié à un système d'alimentation en courant (2), le dispositif comprenant
un dispositif de contrôle (12) électrique pour identifier un défaut d'isolement avec un temps d'erreur respectif et un dispositif d'identification (16) relié au dispositif de contrôle (12) via un canal de communication (14) et servant à identifier le moyen d'opération (8) erroné au moyen d'une propagation de signal caractéristique pour le moyen d'opération (8) respectif quand on met le moyen d'opération (8) en marche ou à l'arrêt à un temps d'erreur, le dispositif d'identification (16) comprenant en outre un dispositif de capture (18) pour capter continument au moins un mesurande électrique dans le système d'alimentation en courant, un dispositif d'évaluation (20) pour identifier un événement de mise en marche/à l'arrêt dans une propagation en espace temporel du mesurande électrique capté et pour associer l'événement de mise en marche/à l'arrêt à un moyen d'opération causant l'événement de mise en marche/à l'arrêt,
un dispositif de stockage (22) pour enregistrer tous les événements de mise en marche/à l'arrêt avec un temps de mise en marche/à l'arrêt et avec le moyen d'opération associé,
un dispositif de signal (24) pour examiner si le temps d'erreur et un temps de fin de défaut coïncide avec un temps de mise en marche/à l'arrêt enregistré et pour signaler le moyen d'opération (8) erroné.

6. Dispositif (10) selon la revendication 5,
**caractérisé en ce que**
le dispositif de contrôle (12) électrique est configuré en tant que contrôleur permanent d'isolement ou en tant qu'appareil de contrôle du courant du mode résiduel.
